# EUROPEAN PATENT APPLICATION

(11) **EP 2 573 578 A1**
(43) Date of publication of application: **27.03.2013**
(21) Application number: 10851777.2
(22) Date of filing: 21.05.2010
(51) Int. Cl.: G01R 31/36

(54) **DIAGNOSIS DEVICE AND DIAGNOSIS METHOD FOR SECONDARY BATTERY, AND VEHICLE**

(71) Applicant: TOYOTA JIDOSHA KABUSHIKI KAISHA, Toyota-shi, Aichi-ken, 471-8571 (JP)
(72) Inventor: MANO, Ryo, Toyota-shi, Aichi 471-8571 (JP); ISHISHITA, Teruo, Toyota-shi, Aichi 471-8571 (JP); MATSUMOTO, Junichi, Toyota-shi, Aichi 471-8571 (JP); TEZUKA, Takayoshi, Toyota-shi, Aichi 471-8571 (JP)
(74) Representative: Intès, Didier Gérard André
(86) International application number: PCT/JP2010/058640
(87) International publication number: WO 2011/145213

(57) **Abstract**

A diagnostic device diagnoses a rechargeable lithium ion battery that is configured of a plurality of battery blocks connected in series for a degraded state attributed to metallic lithium deposited therein. If a condition is established for starting a diagnosis, the diagnostic device starts discharging the battery, and after each battery block has a voltage (Vb) decreased to a measurement starting voltage (Vs) until the block has the voltage (Vb) decreased to a measurement ending voltage (Ve) the block discharges an amount (Q) of power, which the diagnostic device calculates for the battery block. If all blocks each discharge power in an amount (Q) larger than a brand-new product threshold value (A1) the diagnostic device determines that the battery is in a brand new condition. If all blocks each discharge power in an amount (Q) larger than a uselessness threshold value (A2) the diagnostic device determines that the battery is useful. If at least one block discharges power in an amount (Q) smaller than the uselessness threshold value (A2) the diagnostic device determines that the battery is useless.

## Description

### TECHNICAL FIELD

The present invention relates to a technique of diagnosing a rechargeable battery for degradation.

### BACKGROUND ART

In recent years, electrically powered vehicles (hybrid vehicles, electric vehicles, and the like) that obtain driving force through power are gaining a large attention. An electrically powered vehicle is generally equipped with a rechargeable battery to store power therein for driving a motor. The rechargeable battery degrades with time, and if it continues to be used in a degraded state, it will fail. Accordingly, it is important for the electrically powered vehicle to understand how much the rechargeable battery has degraded. In this regard, Japanese Patent Laying-Open No. 2003-143703 (PTL 1) discloses determining degradation of a rechargeable battery of a travelling electric powered vehicle from an amount of power input/output to/from the rechargeable battery and how much in amount the rechargeable battery's stored power currently varies.

### CITATION LIST

### PATENT LITERATURE

PTL 1: Japanese Patent Laying-Open No. 2003-143703
PTL 2: Japanese Patent Laying-Open No. 06-242193
PTL 3: Japanese Patent Laying-Open No. 2000-14019

### SUMMARY OF INVENTION

### TECHNICAL PROBLEM

When a rechargeable lithium ion battery is used, the rechargeable battery has metallic lithium gradually deposited therein as it is used. This degrades the rechargeable battery and varies its characteristics. However, while an electrically powered vehicle is travelling, the rechargeable battery has stored therein an amount of power, which is often maintained in a region higher than that for which a significant variation of a characteristic that is attributed to lithium deposition is presented. Accordingly, it is difficult to accurately determine how much the rechargeable battery has been degraded by lithium deposition from how much power the rechargeable battery receives/outputs in amount and how much its stored power varies in amount while the electrically powered vehicle is travelling.

The present invention has been made to overcome the above disadvantage, and it contemplates determining a degraded state of a rechargeable battery with high precision.

### SOLUTION TO PROBLEM

The present invention provides a diagnostic device for a rechargeable battery, including: a calculation unit that performs a calculation process by discharging the rechargeable battery and calculating as an amount of power discharged for a diagnosis an amount of electric charge discharged from the rechargeable battery while the rechargeable battery decreases in voltage from a first voltage to a second voltage lower than the first voltage with the rechargeable battery having stored therein an amount of power smaller than a predetermined amount; and a diagnostic unit that performs for the rechargeable battery a degradation diagnosis based on the amount of power discharged for the diagnosis.

Preferably, the diagnostic unit sets a threshold value used in the degradation diagnosis, based on a value of a current discharged from the rechargeable battery in the calculation process and a temperature of the rechargeable battery in the calculation process, and the diagnostic unit conducts the degradation diagnosis based on a result of having compared with the threshold value the amount of power discharged for the diagnosis.

Preferably, the diagnostic unit sets a first threshold value used in the degradation diagnosis, based on a value of a current discharged from the rechargeable battery in the calculation process and a lowest temperature in the rechargeable battery in the calculation process, and the diagnostic unit diagnoses from a result of having compared with the first threshold value the amount of power discharged for the diagnosis whether the rechargeable battery is in a first condition indicating that the rechargeable battery is substantially undegraded.

Preferably, the diagnostic unit sets the first threshold value and in addition thereto a second threshold value smaller than the first threshold value. If the amount of power discharged for the diagnosis is larger than the first threshold value, the diagnostic unit diagnoses that the rechargeable battery is in the first condition. If the amount of power discharged for the diagnosis is smaller than the first threshold value and larger than the second threshold value, the diagnostic unit diagnoses that the rechargeable battery is in a second condition indicating that the rechargeable battery is more degraded than the first condition but can still continue to be used. If the amount of power discharged for the diagnosis is smaller than the second threshold value, the diagnostic unit diagnoses that the rechargeable battery is in a third condition indicating that the rechargeable battery is more degraded than the second condition and can no longer continue to be used.

Preferably, if the rechargeable battery has stored therein an amount of power smaller than the predetermined amount the calculation unit performs the calculation process, whereas if the rechargeable battery has stored therein an amount of power larger than the predetermined amount the calculation unit does not perform the calculation process.

Preferably, if the rechargeable battery is higher in voltage than the first voltage the calculation unit performs the calculation process, whereas if the rechargeable battery is lower in voltage than the first voltage the calculation unit does not perform the calculation process.

Preferably, the rechargeable battery is mounted in a vehicle capable of travelling by power of the rechargeable battery. The vehicle includes a control device that calculates and stores as a first amount of power discharged an amount of electric charge discharged from the rechargeable battery while the rechargeable battery decreases in voltage from the first voltage to an intermediate voltage between the first voltage and the second voltage, if a predetermined condition is established while the vehicle is travelling. When the calculation unit performs the calculation process, the calculation unit obtains from the control device the first amount of power discharged, and the calculation unit considers the first amount of power discharged and accordingly calculates the amount of power discharged for the diagnosis.

Preferably, the calculation unit calculates as a second amount of power discharged an amount of electric charge discharged from the rechargeable battery with the vehicle stopped while the rechargeable battery decreases in voltage from the intermediate voltage to the second voltage, and the calculation unit calculates as the amount of power discharged for the diagnosis the first amount of power discharged plus the second amount of power discharged.

Preferably, the rechargeable battery and the diagnostic device are mounted in a vehicle which is capable of travelling by power of the rechargeable battery and includes a charging/discharging device for allowing an external power supply and the rechargeable battery to communicate power therebetween. When the external power supply is connected to the vehicle, the calculation unit controls the charging/discharging device to cause the rechargeable battery to discharge to the external power supply and thus performs the calculation process.

Preferably, when the external power supply is connected to the vehicle, and if the rechargeable battery has stored therein an amount of power smaller than a predetermined amount, the diagnostic device causes the rechargeable battery to discharge to the external power supply to allow the rechargeable battery to have substantially no amount of power stored therein and subsequently starts charging the rechargeable battery, and measures as a power storage capacity of the rechargeable battery an amount of electric charge charged to the rechargeable battery after charging the rechargeable battery is started until the rechargeable battery is fully charged.

Preferably, the rechargeable battery is a rechargeable lithium ion battery.

The present invention in another aspect provides a vehicle including a rechargeable battery which can be subjected to a diagnosis for a degraded state by a diagnostic device. The diagnostic device conducts for the rechargeable battery a degradation diagnosis based on an amount of electric charge discharged from the rechargeable battery while the rechargeable battery decreases in voltage from a first voltage to a second voltage lower than the first voltage with the rechargeable battery having stored therein an amount of power smaller than a predetermined amount. The vehicle includes: a calculation unit that calculates as a first amount of power discharged, an amount of electric charge discharged from the rechargeable battery while the rechargeable battery decreases in voltage from the first voltage to an intermediate voltage between the first voltage and the second voltage, if a predetermined condition is established while the vehicle is travelling; and a storage unit that stores the first amount of power discharged therein to enable the diagnostic device to obtain the first amount of power discharged. While the vehicle is stopped, the diagnostic device obtains from the storage unit the first amount of power discharged, and the diagnostic device considers the first amount of power discharged, and accordingly conducts the degradation diagnosis.

The vehicle may have the diagnostic device therein.

The present invention, in still another aspect, provides a method for a diagnosis conducted by a diagnostic device for a rechargeable battery, including the steps of: performing a calculation process by discharging the rechargeable battery and calculating as an amount of power discharged for the diagnosis, an amount of electric charge discharged from the rechargeable battery while the rechargeable battery decreases in voltage from a first voltage to a second voltage lower than the first voltage with the rechargeable battery having stored therein an amount of power smaller than a predetermined amount; and conducting for the rechargeable battery a degradation diagnosis based on the amount of power discharged for the diagnosis.

### ADVANTAGEOUS EFFECTS OF INVENTION

The present invention thus allows a degraded state of a rechargeable battery to be determined with high precision.

### BRIEF DESCRIPTION OF DRAWINGS

Fig. 1 is a first block diagram for schematically illustrating a vehicle in configuration.
Fig. 2 shows a battery, a temperature sensor, a voltage sensor, and a current sensor schematically.
Fig. 3 is a first functional block diagram of a diagnostic device.
Fig. 4 represents a discharging characteristic of each battery block.
Fig. 5 represents a correspondence between a battery temperature Tb and a battery current Ib, and a brand-new product threshold value A1.
Fig. 6 is a first flowchart to represent a procedure of a process done by the diagnostic device.
Fig. 7 is a second flowchart to represent a procedure of a process done by the diagnostic device.
Fig. 8 is a third flowchart to represent a procedure of a process done by the diagnostic device.
Fig. 9 is a diagram to compare an amount of power discharged when integrating a current is started at a measurement starting voltage Vs and that of power discharged when integrating a current is started at an intermediate voltage Vmid.
Fig. 10 is a functional block diagram of a control circuit and the diagnostic device.
Fig. 11 shows a technique used to calculate a block discharge amount Q0 by the control circuit.
Fig. 12 is a flowchart to represent a procedure of a process done by the control circuit.
Fig. 13 shows a technique used to calculate a block discharge amount Q by the diagnostic device.
Fig. 14 is a fourth flowchart to represent a procedure of a process done by the diagnostic device.
Fig. 15 is a second block diagram for schematically illustrating a vehicle in configuration.
Fig. 16 is a fifth flowchart to represent a procedure of a process done by the diagnostic device.
Fig. 17 is a sixth flowchart to represent a procedure of a process done by the diagnostic device.
Fig. 18 is a seventh flowchart to represent a procedure of a process done by the diagnostic device.

### DESCRIPTION OF EMBODIMENTS

Hereinafter reference will be made to the drawings to describe the present invention in embodiments. In the figures, identical or corresponding components are identically denoted and will not be described repeatedly in principle.

### First Embodiment

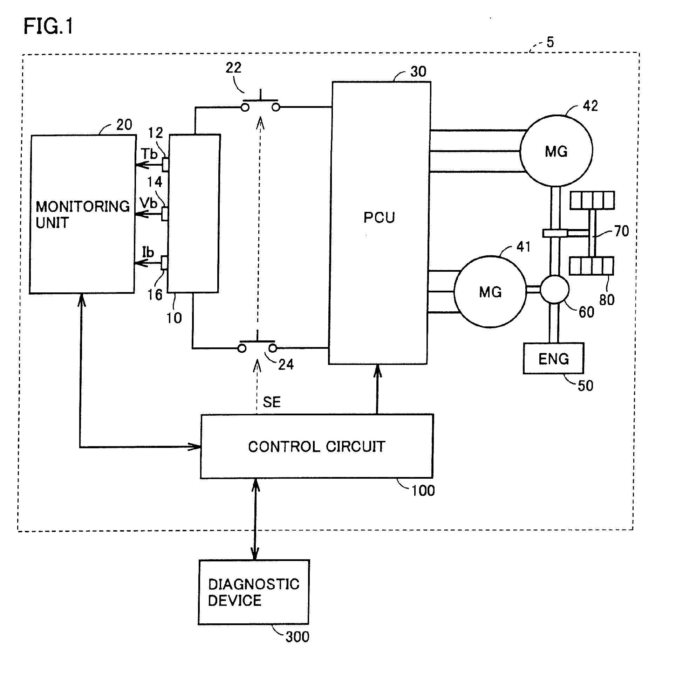

Fig. 1 is a block diagram for illustrating a schematic configuration of a vehicle 5 equipped with a rechargeable battery diagnosed by a diagnostic device 300 according to a first embodiment of the present invention. Note that while vehicle 5 of Fig. 1 is a hybrid vehicle, the present invention is not limited to hybrid vehicles, and is also applicable to electrically powered vehicles in general.

Referring to Fig. 1, vehicle 5 includes a battery 10, system main relays 22 and 24, a power controls unit (PCU) 30, motor generators 41 and 42, an engine 50, a power split device 60, a driving shaft 70, and a wheel 80.

Battery 10 is a rechargeable lithium ion battery. Battery 10 is formed of a plurality of rechargeable lithium ion battery cells connected in series.

Engine 50 outputs kinetic energy through energy generated by combusting fuel. Power split device 60 is coupled with the output shafts of motor generators 41 and 42 and engine 50 to use the output(s) of motor generator 42 and/or engine 50 to drive driving shaft 70, which in turn rotates wheel 80. Vehicle 5 thus travels on the output(s) of engine 50 and/or motor generator 42.

While motor generators 41 and 42 may function as a power generator as well as an electric motor, motor generator 41 operates mainly as a power generator and motor generator 42 operates mainly as an electric motor.

More specifically, motor generator 41 is employed as a starter to start engine 50 for acceleration or similarly when starting the engine is requested. At the time, motor generator 41 receives power from battery 10 via PCU 30 to be driven as an electric motor to crank and thus start engine 50. Furthermore, after engine 50 is started, motor generator 41 can be rotated by an output of the engine transmitted via power split device 60 to generate power.

Motor generator 42 is driven by at least one of the power stored in battery 10 and the power generated by motor generator 41. Motor generator 42 provides driving force which is in turn transmitted to driving shaft 70. Motor generator 42 thus assists engine 50 to cause vehicle 5 to travel, or provides driving force to alone cause vehicle 5 to travel.

Furthermore, when vehicle 5 is regeneratively braked, motor generator 42 is driven by the wheel's torque to operate as a power generator. At the time, motor generator 42 regenerates power which is in turn charged via PCU 30 to battery 10.

PCU 30 performs bidirectional power conversion between battery 10 and motor generators 41 and 42, and also controls the power conversion so that motor generators 41 and 42 operate in accordance with operation command values (representatively, torque command values), respectively. For example, PCU 30 includes an inverter or the like to receive direct current power from battery 10, convert it into alternating current power, and apply it to motor generators 41 and 42. This inverter can also convert the power that is regenerated by motor generators 41 and 42 into direct current power to charge battery 10 therewith.

System main relays 22 and 24 are provided between PCU 30 and battery 10. System main relays 22 and 24 are turned on/off in response to a relay control signal SE. When system main relays 22 and 24 are turned off (or opened), a path to charge/discharge battery 10 is mechanically interrupted.

Vehicle 5 further includes a monitoring unit 20 for monitoring battery 10, and a control circuit 100.

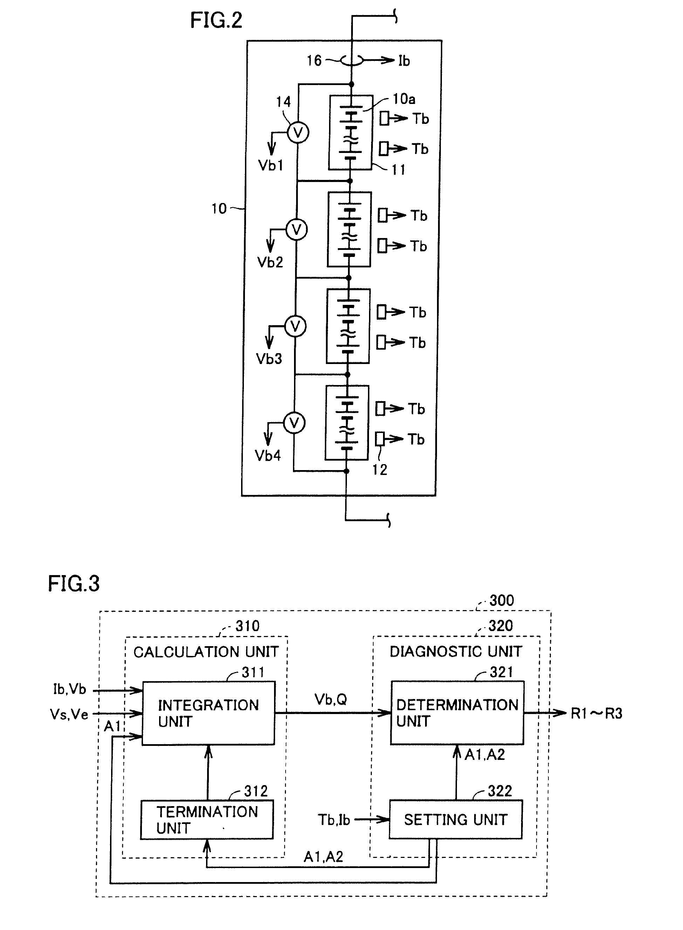

Monitoring unit 20 monitors a result as sensed by a temperature sensor 12, a voltage sensor 14 and a current sensor 16 provided for battery 10, and outputs the result to control circuit 100. Note that while Fig. 1 shows temperature sensor 12 and voltage sensor 14 collectively, in reality, as will be shown in Fig. 2, a plurality of temperature sensors 12 and a plurality of voltage sensors 14 are provided.

Fig. 2 shows battery 10, temperature sensor 12, voltage sensor 14, and current sensor 16 in configuration.

Battery 10 is configured of n battery blocks 11 connected in series, wherein n is an integer equal to or larger than 2. Note that Fig. 2 shows a configuration for N = 4 by way of example. Each battery block 11 is configured of a plurality of battery cells 10a connected in series.

A plurality of temperature sensors 12 are provided for each battery block 11. Note that Fig. 2 illustrates a configuration with two temperature sensors 12 provided for each battery block 11 by way of example. Each temperature sensor 12 senses the temperature at its location as a battery temperature Tb.

Voltage sensor 14 is provided, one for each battery block 11. Each voltage sensor 14 senses a block voltage Vb (Vb1-Vbn) across battery block 11 associated therewith. Note that Fig. 2 illustrates a configuration with battery blocks 11 sensing block voltages Vb1-Vb4, respectively, by way of example.

Current sensor 16 senses a battery current Ib passing through battery 10. Note that a plurality of current sensors 16 may be provided.

Each temperature sensor 12, each voltage sensor 14, and current sensor 16 sense temperature, voltage and current, which are transmitted as a sensed result to control circuit 100 via monitoring unit 20.

Referring back to Fig. 1, control circuit 100 is configured of an electronic control unit (ECU) having a central processing unit (CPU) and a memory (not shown) incorporated therein, and performs a predetermined operation process based on each sensor's sensed result and information and the like stored in the memory.

Control circuit 100 operates in response to an amount by which the user operates the accelerator, the vehicle's speed and the like to set a value of torque requested for motor generators 41 and 42. Control circuit 100 controls PCU 30 to provide power conversion so that motor generators 41 and 42 operate in accordance with this requested torque value. Note that engine 50 is controlled by another ECU which is not shown. Furthermore, while Fig. 1 shows control circuit 100 as a single unit, is may be two or more discrete units.

Vehicle 5 is configured to be connectable to diagnostic device 300. The first embodiment will be described with diagnostic device 300 provided in a dealer or a similar repair shop for the sake of illustration. Note that diagnostic device 300 may be provided inside vehicle 5.

Diagnostic device 300 is similar in configuration to control circuit 100, configured of an electronic control unit having a CPU and a memory (not shown) incorporated therein.

Diagnostic device 300 is operated by a serviceman or the like who works in the repair shop. Once diagnostic device 300 has been connected to vehicle 5, a state is established to allow diagnostic device 300 and control circuit 100 to communicate with each other. Diagnostic device 300 communicates with control circuit 100 to diagnose rechargeable battery 10 for degradation (hereinafter a diagnosis conducted by diagnostic device 300 will also be referred to as a "battery diagnosis").

Diagnostic device 300 conducts the battery diagnosis, as will be described hereinafter. When battery 10 or a similar rechargeable lithium ion battery is used for a long period of time, there is a possibility that it may have metallic lithium deposited therein and degrade.

If the rechargeable lithium ion battery is discharged in a range in which it has a small amount of power stored therein, its voltage decreases by an amount, which is larger for larger amounts of lithium deposited therein even for a specific given amount of power discharged therefrom. In other words, when the battery has its voltage decreased by a specific given amount, it discharges power in smaller amounts for larger amounts of lithium deposited therein (hereinafter, this characteristic will also be referred to as a "low-range characteristic").

Diagnostic device 300 exploits this low-range characteristic to diagnose rechargeable battery 10 for a degraded state attributed to metallic lithium deposited therein. Specifically, battery 10 having stored therein an amount of power smaller than a predetermined amount (or falling within a "low SOC range" hereinafter) is decreased in voltage by a predetermined voltage, and diagnostic device 300 calculates an amount of power (or electric charge) discharged from battery 10, and from the calculated discharged amount, diagnostic device 300 diagnoses rechargeable battery 10 for a degraded state attributed to metallic lithium deposited therein.

Fig. 3 is a functional block diagram of a portion of diagnostic device 300 that is involved in the battery diagnosis. Note that each functional block shown in Fig. 3 may be implemented by hardware processing by electronic circuitry or the like, or by software processing by executing a program or the like.

Diagnostic device 300 includes a calculation unit 310 and a diagnostic unit 320.

Calculation unit 310 calculates an amount of power discharged from battery 10 with its voltage decreased by a predetermined voltage while battery 10 falls within the low SOC range. From the discharged amount as calculated by calculation unit 310, diagnostic unit 320 diagnoses battery 10 for a degraded state attributed to metallic lithium deposited therein.

Hereinafter, calculation unit 310 will be described. Calculation unit 310 includes an integration unit 311 and a termination unit 312.

Once diagnostic device 300 has been connected to vehicle 5, integration unit 311 starts to communicate with control circuit 100 of vehicle 5 to receive information from control circuit 100, including each battery temperature Tb, each block voltage Vb, battery current Ib, and the like, and transmit instructions to control circuit 100 to perform the following process.

Integration unit 311 initially determines whether a condition has been established for starting the battery diagnosis. The condition for starting the battery diagnosis is for example that vehicle 5 has its electronics in an operable state (or is in the IG-on state) and is also stopped and that there is no error found in the information received from control circuit 100.

If the condition for starting the battery diagnosis has been established, integration unit 311 starts discharging battery 10 and also performs a current integration process as will be described hereinafter. Battery 10 discharges electric charge, which is charged via a DC-DC converter (not shown) to an auxiliary battery (not shown) mounted in vehicle 5. Note the electric charge discharged from battery 10 may be consumed by other electronics.

Integration unit 311 performs the current integration process, as will be described hereinafter. Initially, once block voltage Vb has decreased to a measurement starting voltage Vs, integration unit 311 starts to integrate battery current Ib. Then, once block voltage Vb has decreased to measurement starting voltage Vs minus a predetermined voltage, or a measurement ending voltage Ve, or once battery current Ib has attained an integrated value equal to or larger than a brand-new product threshold value A1, which will be described hereinafter, integration unit 311 ends integrating battery current Ib and stores the integrated value of battery current Ib to the memory. This series of steps is the current integration process.

The current integration process involves measurement starting voltage Vs and measurement ending voltage Ve, which are previously set at values falling within a range in which block voltage Vb varies for the low SOC range described above. In other words, the integrated current value obtained through the current integration process indicates an amount of power discharged from battery block 11 when its voltage is decreased only by a predetermined voltage for the low SOC range. Note that hereinafter the integrated current value obtained through the current integration process will also be referred to as a "block discharged amount Q (an amount Q of power discharged from a block or the like)".

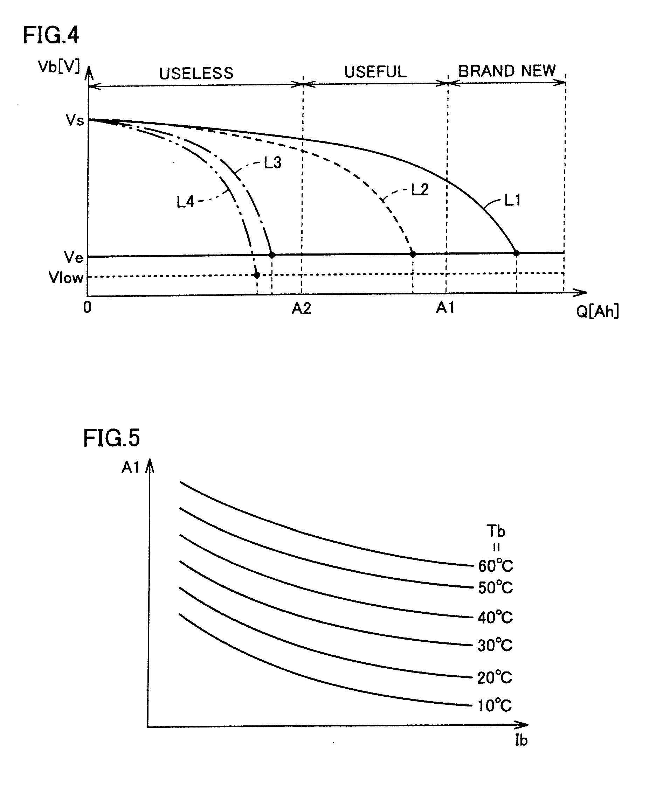

Fig. 4 represents a discharging characteristic of each battery block 11 exhibited when the current integration process is performed. As has been described above, the current integration process integrates a current while block voltage Vb decreases from measurement starting voltage Vs to measurement ending voltage Ve, and the integrated current value is presented as block discharged amount Q.

Block discharged amount Q is smaller for larger amounts of lithium deposited therein, as has been described above by referring to the low-range characteristic above. That is, an amount of metallic lithium deposited in battery block 11 can be determined from the magnitude of block discharged amount Q thereof. As indicated in Fig. 4 by a solid line L1, battery block 11 discharging power in amount Q equal to or larger than brand-new product threshold value A1, which will be described later, is in a condition without substantial metallic lithium deposition (hereinafter also referred to as a "brand-new condition"). As indicated in Fig. 4 by a broken line L2, battery block 11 discharging power in amount Q smaller than brand-new product threshold value A1 and larger than a uselessness threshold value A2, which will be described later, is more degraded than the brand-new condition but still does not have lithium deposited therein in a large amount and can thus continue to be used. As indicated in Fig. 4 by an alternate long and short dashed line L3, battery block 11 discharging power in amount Q further decreased below uselessness threshold value A2 has a large amount of lithium deposited therein and can thus no longer continue to be used.

Integration unit 311 performs the current integration process for each of block voltages Vbl-Vbn (or for each battery block 11) individually. Accordingly, for block voltages Vbl-Vbn, block discharged amounts Ql-Qn, respectively, are calculated.

Note that Fig. 4 also shows a chain double-dashed line L4, which indicates a discharging characteristic presented as the current integration process is performed when block voltage Vb further decreases below measurement ending voltage Ve and has reached an overdischarge threshold value Vlow. A battery block which has a significantly large amount of lithium deposited therein and is thus significantly degraded has block voltage Vb decreased to measurement ending voltage Ve earlier than the other battery blocks, and accordingly, the current integration process ends earlier for that battery block. However, the current integration process continues for the other battery blocks until a condition is established for ending the current integration process, as will be described later, and the battery block that no longer undergoes the current integration process also still continues to discharge. As a result, the significantly degraded battery block may have block voltages Vb decreased to overdischarge threshold value Vlow, as indicated in Fig. 4 by chain double-dashed line L4.

Referring back to Fig. 3, termination unit 312 determines whether a condition is established for ending the current integration process, as below, and once the condition for ending the current integration process has been established, termination unit 312 ends the current integration process performed by integration unit 311*.* The condition for ending the current integration process includes a condition for normally ending the current integration process and a condition for aborting the current integration process.

The condition for normally ending the current integration process is a condition applied to normally end the current integration process performed by integration unit 311 and shift to a determination process for the battery diagnosis conducted by diagnostic unit 320. Termination unit 312 determines that the condition for normally ending the current integration process has been established and accordingly termination unit 312 normally ends the current integration process, for example if any of the following conditions (a1) to (a4) is established:
(a1) block discharged amounts Ql-Qn are all equal to or larger than brand-new product threshold value A1;
(a2) block voltages Vbl-Vbn are all equal to or smaller than measurement ending voltage Ve;
(a3) at least one of block voltages Vbl-Vbn is equal to or smaller than measurement ending voltage Ve, and block discharged amount Q associated therewith is smaller than uselessness threshold value A2; or
(a4) at least one of block voltages Vbl-Vbn is equal to or smaller than overdischarge threshold value Vlow.

Note that when the current integration process normally ends, integration unit 311 outputs block discharged amounts Ql-Qn, as obtained when the current integration process normally ends, together with block voltages Vbl-Vbn to diagnostic unit 320.

In contrast, the condition for aborting the current integration process is a condition applied to abort the current integration process performed by integration unit 311. Termination unit 312 determines that the condition for aborting the current integration process has been established and accordingly termination unit 312 aborts the current integration process, for example if any of the following conditions (b1) to (b4) is established:
(b1) control circuit 100 provides information having some error;
(b2) battery temperature Tb does not fall within a predetermined temperature range;
(b3) an operation has been done to turn off ignition (an operation to turn off IG); or
(b4) time has elapsed beyond an upper limit time since the current integration process was started.

Note that when the current integration process is aborted, the process is not shifted to the determination process for the battery diagnosis conducted by diagnostic unit 320.

Diagnostic unit 320 will be described hereinafter. Diagnostic unit 320 receives block discharged amount Q (Ql-Qn) and block voltage Vb (Vbl-Vbn) from calculation unit 310 and therefrom diagnoses battery 10 for a degraded state attributed to metallic lithium deposited therein. Diagnostic unit 320 includes a determination unit 321 and a setting unit 322.

When the current integration process is normally ended, determination unit 321 determines whether the following first to third conditions are established or not, and in accordance therewith determination unit 321 performs a determination process to determine a degraded state of battery 10 attributed to metallic lithium deposited therein.

The first condition is that block discharged amounts Ql-Qn are all equal to or larger than brand-new product threshold value A1 (see solid line L1 in Fig. 4). If the first condition is established, determination unit 321 determines that battery 10 is in the brand-new condition, and determination unit 321 outputs a signal R1 indicative of the brand-new condition.

The second condition is that at least one of block voltages Vbl-Vbn is equal to or smaller than measurement ending voltage Ve and block discharged amount Q associated therewith is smaller than uselessness threshold value A2 (see alternate long and short dashed line L3 in Fig. 4).

The third condition is that at least one block voltage Vb is equal to or smaller than overdischarge threshold value Vlow (see chain double-dashed line L4 in Fig. 4), and block discharged amounts Ql-Qn are all smaller than uselessness threshold value A2.

If the second or third condition is established, determination unit 321 determines that battery 10 is useless, and determination unit 321 outputs a signal R2 indicative of uselessness.

If none of the first to third conditions is established (see broken line L2 in Fig. 4), determination unit 321 determines that battery 10 is useful, and determination unit 321 outputs a signal R3 indicative of usefulness.

Determination unit 321 thus provides a determination, which is in turn displayed on a display of diagnostic device 300, an information panel of vehicle 5 or the like and the user is thus informed thereof.

Setting unit 322 sets brand-new product threshold value A 1 and uselessness threshold value A2 based on battery temperature Tb and battery current Ib obtained while the current integration process is performed.

Fig. 5 represents a correspondence between battery temperature Tb and battery current Ib obtained while the current integration process is performed, and brand-new product threshold value A1. Even in the brand-new condition, battery 10 at low temperature discharges power in a reduced amount, and accordingly, setting unit 322 sets brand-new product threshold value A 1 to smaller values for lower battery temperatures Tb obtained while the current integration process is performed. This prevents brand-new battery 10 at low temperature from being erroneously determined as having a condition other than the brand-new condition.

Brand-new product threshold value A1 may be set to a single value applied to all battery blocks 11, or may be set to a different value for each battery block 11. In any case, desirably, brand-new product threshold value A1 is set with reference to battery temperature Tb that is the lowest temperature in battery 10 (the lowest temperature in each battery block 11, if required). For lower lowest temperatures in battery 10, brand-new product threshold value A1 is set to lower values, which ensure preventing brand-new battery 10 from being erroneously determined as having a condition other than the brand-new condition.

Furthermore, setting unit 322 sets brand-new product threshold value A1 to have smaller values for larger values of battery current Ib obtained while the current integration process is performed, as shown in Fig. 5.

As well as brand-new product threshold value A1, setting unit 322 sets uselessness threshold value A2 based on battery temperature Tb and battery current Ib obtained while the current integration process is performed. Note that uselessness threshold value A2 may be set in a different manner or may have a fixed value.

Setting unit 322 thus sets brand-new product threshold value A 1 and uselessness threshold value A2, which are in turn output to determination unit 321 and used for the aforementioned determination process. Furthermore, brand-new product threshold value A1 and uselessness threshold value A2 are also output to calculation unit 310 and used in the current integration process and determining the condition for ending the current integration process.

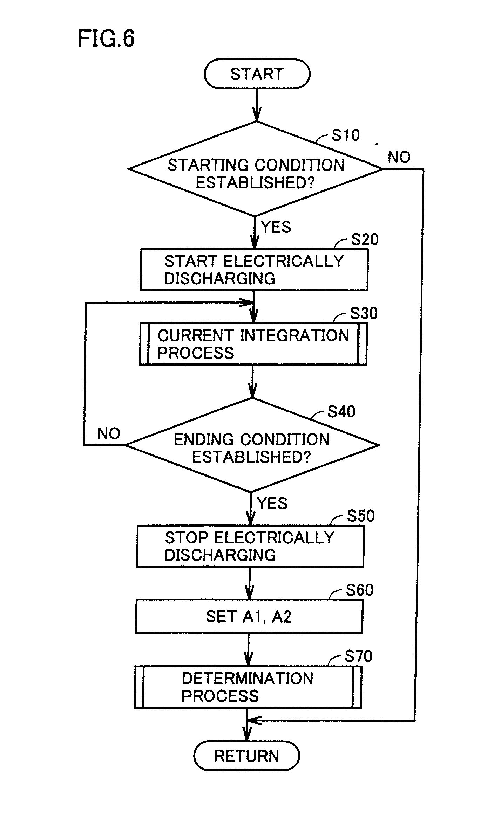

Fig. 6 is a flowchart representing a procedure of a process performed by diagnostic device 300 to implement the above described function. Note that each step (hereinafter abbreviated as "S") of the flowchart indicated hereinafter may be implemented by hardware processing or software processing, as has been set forth above.

In S10, diagnostic device 300 determines whether the condition for starting the battery diagnosis has been established. If so (YES at S10), the control proceeds to S20. Otherwise (NO at S10), this process ends.

In S20, diagnostic device 300 starts discharging battery 10. In S30, diagnostic device 300 performs the current integration process.

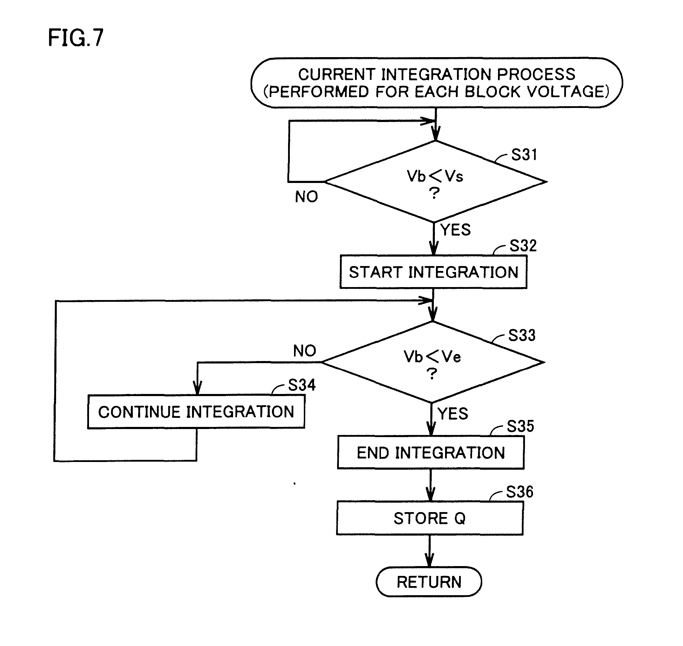

Fig. 7 is a flowchart representing a procedure of a process performed by diagnostic device 300 when the current integration process is performed. Note that this process is performed for each battery block 11 individually.

In S31, diagnostic device 300 determines whether block voltage Vb has decreased below measurement starting voltage Vs. If so (YES at S31), the control proceeds to S32. Otherwise (NO at S31), the control returns to S31. In S32, diagnostic device 300 starts integrating battery current Ib.

In S33, diagnostic device 300 determines whether block voltage Vb has decreased below measurement ending voltage Ve. If so (YES at S33), the control proceeds to S35. Otherwise (NO at S33), the control proceeds to S34.

In S34, diagnostic device 300 continues to integrate battery current Ib. The control thereafter returns to S33.

In S35, diagnostic device 300 ends integrating battery current Ib. In S36, diagnostic device 300 stores the integrated value of battery current Ib that is obtained when the integration ends to the memory as block discharged amount Q. Note that the current integration process is performed for each battery block 11 individually, and accordingly, n block discharged amounts Q (block discharged amounts Ql-Qn) are stored to the memory.

Returning back to Fig. 6, in S40, diagnostic device 300 determines whether the condition for ending the current integration process (the condition for normally ending the process or that for aborting the process) has been established. If so (YES at S40), the control proceeds to S50. Otherwise (NO at S40), the control returns to S30. Note that while Fig. 6 shows the S30 current integration process followed by the S40 determination, in reality, the S40 determination is also made during the S30 current integration process. In other words, when the condition for ending the current integration process is established during the S30 current integration process, the control proceeds to S50.

In S50, diagnostic device 300 ends the S30 current integration process and stops discharging battery 10.

In S60, diagnostic device 300 employs the above described technique (see the Fig. 5 map) to set brand-new product threshold value A1 and uselessness threshold value A2.

In S70, diagnostic device 300 performs the aforementioned determination process.

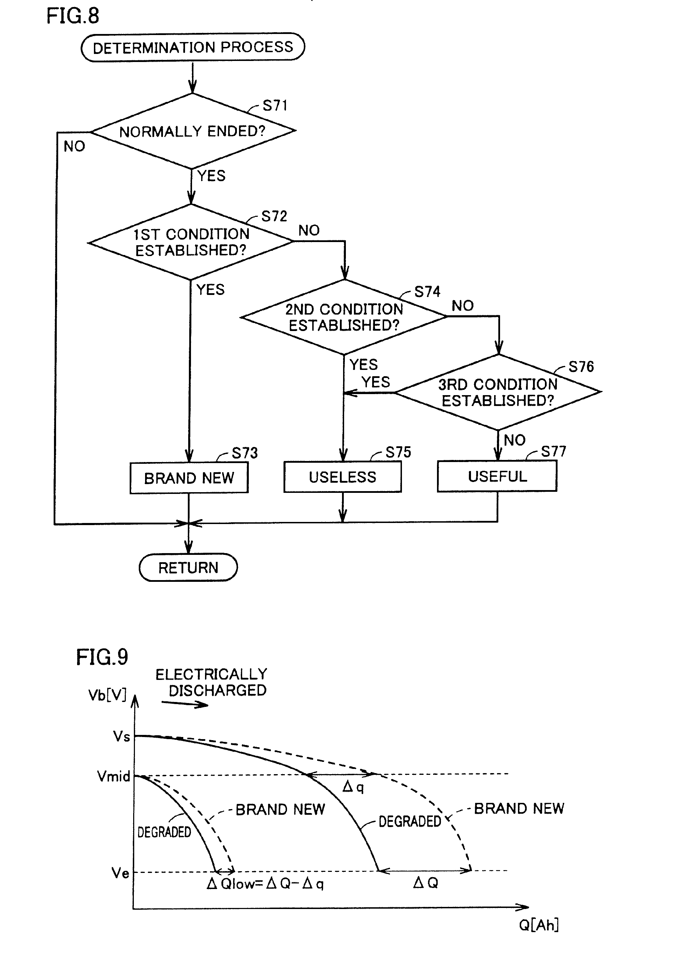

Fig. 8 is a flowchart representing a procedure of a process performed by diagnostic device 300 when the determination process is performed.

In S71, diagnostic device 300 determines whether the current integration process has ended normally. If so (YES at S71), the control proceeds to S72. Otherwise (NO at S71), this process ends and the determination process is not performed.

In S72, diagnostic device 300 determines whether the first condition has been established. The first condition is that block discharged amounts Q1-Qn are all equal to or larger than brand-new product threshold value A1, as has been set forth above. If the first condition has been established (YES at S72), the control proceeds to S73. Otherwise (NO at S72), the control proceeds to S74.

In S73, diagnostic device 300 determines that battery 10 is in the "brand-new condition."

In S74, diagnostic device 300 determines whether the second condition has been established. The second condition is that at least one of block voltages Vb1-Vbn is equal to or smaller than measurement ending voltage Ve and block discharged amount Q associated therewith is smaller than uselessness threshold value A2, as has been set forth above. If the second condition has been established (YES at S74), the control proceeds to S75. Otherwise (NO at S74), the control proceeds to S76.

In S75, diagnostic device 300 determines that battery 10 is useless.

In S76, diagnostic device 300 determines whether the third condition has been established. The third condition is that at least one block voltage Vb is equal to or smaller than overdischarge threshold value Vlow and block discharged amounts Q1-Qn are all smaller than uselessness threshold value A2, as has been set forth above. If the third condition has been established (YES at S76), the control proceeds to S75. Otherwise (NO at S76), the control proceeds to S77.

In S77, diagnostic device 300 determines that battery 10 is useful.

Thus in the first embodiment battery 10 in a low SOC range with each block voltage decreased from measurement starting voltage Vs to measurement ending voltage Ve discharges an amount of power, which diagnostic device 300 calculates for each block of battery 10 and therefrom diagnoses battery 10 for a degraded state attributed to metallic lithium deposited therein. For the low SOC range a battery decreased in voltage by a specific given amount discharges power in smaller amounts for larger amounts of lithium deposited therein (i.e., the low-range characteristic), and a degraded state of battery 10 attributed to metallic lithium deposited therein can be determined with high precision.

### Second Embodiment

As has been described above, to determine a degraded state of battery 10 by exploiting the low-range characteristic, measurement starting voltage Vs used in the current integration process is required to be set to a value falling within a range in which block voltage Vb varies when battery 10 is in the low SOC range. Accordingly, measurement starting voltage Vs is required to be set to a relatively small value. On the other hand, excessively low measurement starting voltage Vs results in low precision for determination.

Fig. 9 is a diagram to compare an amount of power discharged when integrating a current is started at measurement starting voltage Vs and that of power discharged when integrating a current is started at an intermediate voltage Vmid between measurement starting voltage Vs and measurement ending voltage Ve.

A degraded rechargeable battery discharges an amount of power (indicated by a solid line) and a rechargeable battery in the brand-new condition discharges an amount of power (indicated by a broken line) and their difference is a value corresponding to an amount of metallic lithium deposited in a rechargeable battery to be diagnosed, and this difference starts when block voltage Vb is still relatively high. Accordingly, as indicated in Fig. 9, when block voltage Vb is decreased from measurement starting voltage Vs to intermediate voltage Vmid, the degraded rechargeable battery and the rechargeable battery in the brand-new condition already have a difference Δq between their respective discharged amounts. Accordingly, when integrating a current is started at intermediate voltage Vmid, difference Δq will not be added to an amount of power discharged obtained as a result of the current integration process. That is, when integrating a current is started at intermediate voltage Vmid, the batteries have a difference ΔQlow between their respective discharged amounts, which is smaller by Δq than a difference ΔQ between their respective discharged amounts provided when integrating a current is started at measurement starting voltage Vs, resulting in accordingly impaired precision for determination.

Accordingly, when the condition for starting the battery diagnosis is established, and at the time if block voltage Vb is lower than measurement starting voltage Vs, then, to avoid impaired precision for determination, it is necessary to charge battery 10 once to increase each block voltage Vb1-Vbn to measurement starting voltage Vs, and thereafter perform the current integration process, which requires an increased period of time for the battery diagnosis.

To address this issue, in the second embodiment, an integrated value of battery current Ib obtained while block voltage Vb decreases from measurement starting voltage Vs to intermediate voltage Vmid (hereinafter "block discharged amount Q0") is previously calculated and stored by control circuit 100a while vehicle 5 is travelling (while it is normally driven). Then diagnostic device 300a conducts the battery diagnosis while vehicle 5 is stopped, and in the battery diagnosis, diagnostic device 300a calculates an integrated value of battery current Ib obtained while block voltage Vb decreases from intermediate voltage Vmid to measurement ending voltage Ve (hereinafter referred to as a "block discharged amount Qd"), and diagnostic device 300a also reads from control circuit 100a block discharged amount Q0 that was stored while vehicle 5 was travelling. Diagnostic device 300a adds block discharged amount Qd and block discharged amount Q0 together as block discharged amount Q and uses it to perform the determination process.

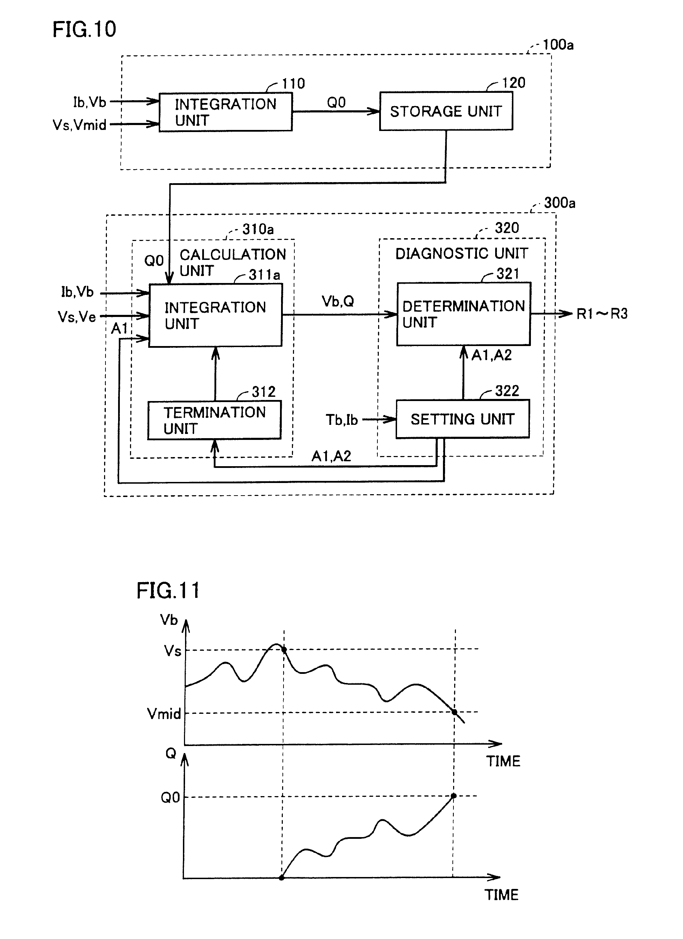

Fig. 10 is a functional block diagram of a portion of control circuit 100a and diagnostic device 300a that is involved in the battery diagnosis according to the second embodiment. The second embodiment will be described with diagnostic device 300a provided in a dealer or a similar repair shop for the sake of illustration. Note that diagnostic device 300a may be provided inside vehicle 5, as has been described in the first embodiment.

Control circuit 100a includes integration unit 110 and storage unit 120. While vehicle 5 is travelling, integration unit 110 calculates an integrated value of battery current Ib that is obtained for the voltage from measurement starting voltage Vs to intermediate voltage Vmid, and integration unit 110 stores the calculated integrated value to storage unit 120 as block discharged amount Q0.

Fig, 11 shows a technique used in control circuit 100a to calculate block discharged amount Q0. As indicated in Fig. 11, integration unit 110 starts integrating battery current Ib when block voltage Vb is decreased below measurement starting voltage Vs, and integration unit 110 ends the integration when block voltage Vb is decreased to intermediate voltage Vmid. Then, the integrated value that is obtained when the integration ends is stored to storage unit 120 as block discharged amount Q0. Note that block discharged amount Q0 is calculated for each battery block 11. Accordingly, for n battery blocks 11, n block discharged amounts Q0 (Q01-Q0n), respectively, are stored to storage unit 120. Note that battery 10 which is used only for a relatively short period of time and thus not degraded to a large extent would not likely need to be subject to the battery diagnosis, and accordingly, block discharged amount Q0 may be calculated for example only once for one trip after battery 10 is used beyond a predetermined period of years.

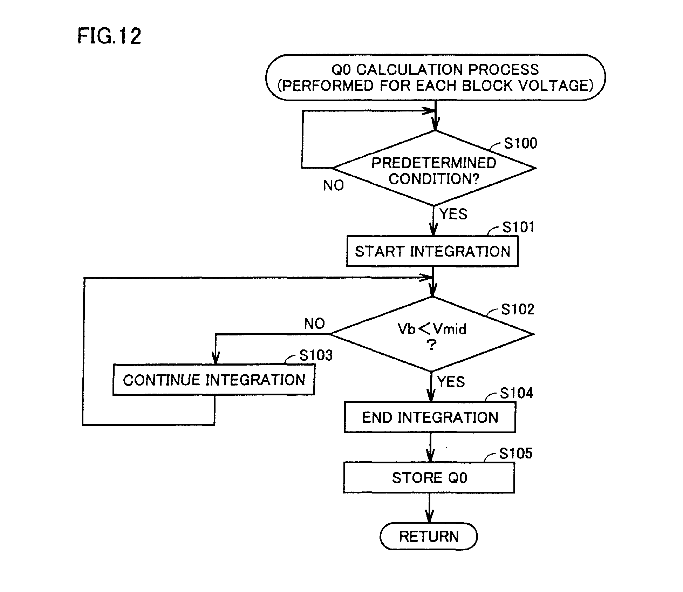

Fig. 12 is a flowchart representing a procedure of a process performed by control circuit 100a in calculating block discharged amount Q0. Note that this process is performed for each battery block 11 individually.

In S 100, control circuit 100a determines whether a predetermined condition has been established while vehicle 5 is travelling. The predetermined condition is as follows: the battery of interest is in the low SOC range, battery temperature Tb falls within a predetermined temperature range and battery current Ib falls within a predetermined range, and in that state, block voltage Vb has decreased below measurement starting voltage Vs. This condition is a condition for ensuring accuracy for calculation of block discharged amount Q0 (i.e., precision for determination in the battery diagnosis), as will be described later. If the predetermined condition is established (YES at S 100), the control proceeds to S 101. Otherwise (NO at S100), the control returns to S 100. In S 101, control circuit 100a starts integrating battery current Ib.

In S102, control circuit 100a determines whether block voltage Vb has decreased below intermediate voltage Vmid. If so (YES at S 102), the control proceeds to S104. Otherwise (NO at S102), the control proceeds to S 103.

In S 103, control circuit 100a continues to integrate battery current Ib. The control thereafter returns to S102.

In S 104, control circuit 100a ends integrating battery current Ib.

In S106, control circuit 100a stores the integrated value of battery current Ib to storage unit 120 as block discharged amount Q0. Note that this process is performed for each battery block 11 individually, and accordingly, n block discharged amounts Q0 (Q01-Q0n) are stored to storage unit 120.

Referring back to Fig. 10, diagnostic device 300a has a function, as described hereinafter. Diagnostic device 300a includes a calculation unit 310a and a diagnostic unit 320. Calculation unit 310a includes an integration unit 311a and a termination unit 312. How termination unit 312 and diagnostic unit 320 function has been described in the first embodiment, and accordingly it will not be described repeatedly in detail.

Integration unit 311a employs a technique similar to that of the first embodiment, with intermediate voltage Vmid set as a voltage for which integrating a current starts, to perform the current integration process to calculate block discharged amount Qd (Qd1-Qdn) obtained while block voltage Vb decreases from intermediate voltage Vmid to measurement ending voltage Ve.

Then, if the condition for normally ending the current integration process is established, integration unit 311a reads block discharged amount Q0 from storage unit 120 of vehicle 5, adds the read block discharged amount Q0 and the calculated block discharged amount Qd together as block discharged amount Q, and outputs it to determination unit 321.

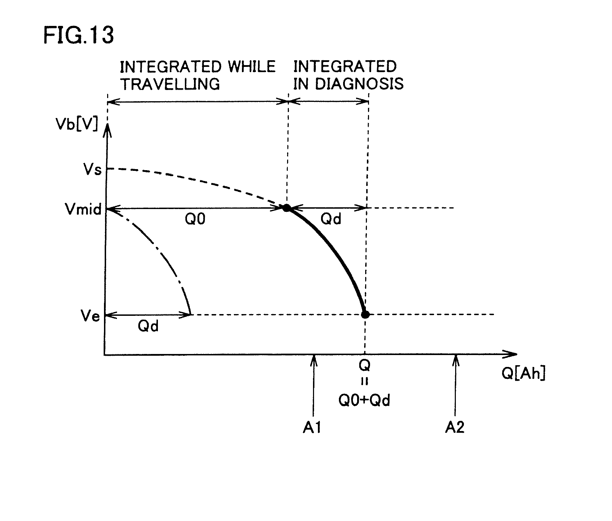

Fig. 13 shows a technique used in integration unit 311a to calculate block discharged amount Q. Block discharged amount Q0 obtained while block voltage Vb decreases from measurement starting voltage Vs to intermediate voltage Vmid is previously calculated by control circuit 100a and stored while vehicle 5 is travelling. If block voltage Vb provided when the condition for starting the battery diagnosis is established as lower than measurement starting voltage Vs, block voltage Vb is not increased to measurement starting voltage Vs (i.e., battery 10 is not charged), and integration unit 311a starts the current integration process at intermediate voltage Vmid to calculate block discharged amount Qd, and integration unit 311a adds block discharged amount Q0 that is read from control circuit 100a and block discharged amount Qd together as block discharged amount Q. Note that this process is also performed for each battery block 11 individually. More specifically, integration unit 311a adds block discharged amounts Q01-Q0n and block discharged amounts Qd1-Qdn together as block discharged amounts Q1-Qn, respectively.

This allows the diagnosis to be done simply by calculating block discharged amount Qd that is obtained while block voltage Vb decreases from intermediate voltage Vmid to measurement ending voltage Ve to calculate block discharged amount Q obtained while block voltage Vb decreases from measurement starting voltage Vs to measurement ending voltage Ve. That is, if block voltage Vb provided when the diagnosis starts is lower than measurement starting voltage Vs, it is not necessary to increase block voltage Vb to measurement starting voltage Vs in calculating block discharged amount Q obtained while block voltage Vb decreases from measurement starting voltage Vs to measurement ending voltage Ve. This allows the diagnosis to be conducted accurately in a reduced period of time.

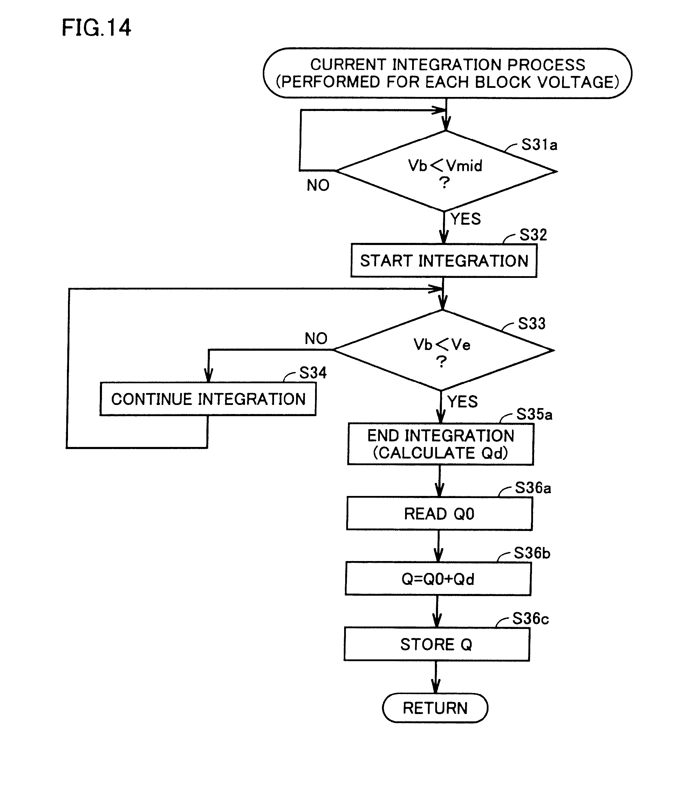

Fig. 14 is a flowchart to represent a procedure of the current integration process done by diagnostic device 300a. Note that in the Fig. 14 flowchart, those steps which are identical to those in the Fig. 7 flowchart are identically denoted. Accordingly they will not be described repeatedly in detail.

In S31a, diagnostic device 300a determines whether block voltage Vb has decreased below intermediate voltage Vmid. If so (YES at S31a), the control proceeds to S32. Otherwise (NO at S31a), the control returns to S31 a.

In S35a, diagnostic device 300a ends integrating battery current Ib. At this point in time, an integrated value of battery current Ib is obtained, which corresponds to block discharged amount Qd obtained while block voltage Vb decreases from intermediate voltage Vmid to measurement ending voltage Ve.

In S36a, diagnostic device 300a reads block discharged amount Q0 described in control circuit 100a of vehicle 5.

In S36b, diagnostic device 300a adds block discharged amount Q0 that is read from control circuit 100a and block discharged amount Qd that is calculated in the current integration process together as block discharged amount Q.

In S36c, diagnostic device 300a stores the calculated block discharged amount Q (= Q0 + Qd) to the memory. The block discharged amount Q that is stored by this process (= Q0 + Qd) is used in the subsequent, determination process (see Fig. 6, S70, and Fig. 7).

Thus, in the second embodiment, block discharged amount Q0 obtained while block voltage Vb decreases from measurement starting voltage Vs to intermediate voltage Vmid is previously calculated and stored while vehicle 5 is traveling. Then, in the diagnosis, block discharged amount Qd is calculated while block voltage Vb decreases from intermediate voltage Vmid to measurement ending voltage Ve, and block discharged amount Q0 and block discharged amount Qd are together considered in conducting the battery diagnosis. This allows the diagnosis to be conducted accurately in a reduced period of time.

### Third Embodiment

In the first embodiment, when the current integration process is performed the electric charge stored in battery 10 is discharged to an auxiliary battery internal to vehicle 5. Furthermore, in the first embodiment, diagnostic device 300 is provided outside vehicle 5.

In the third embodiment, in contrast, when the current integration process is performed the electric charge stored in battery 10 is discharged to a power supply provided outside a vehicle. Furthermore, in the third embodiment, diagnostic device 300 is provided inside the vehicle.

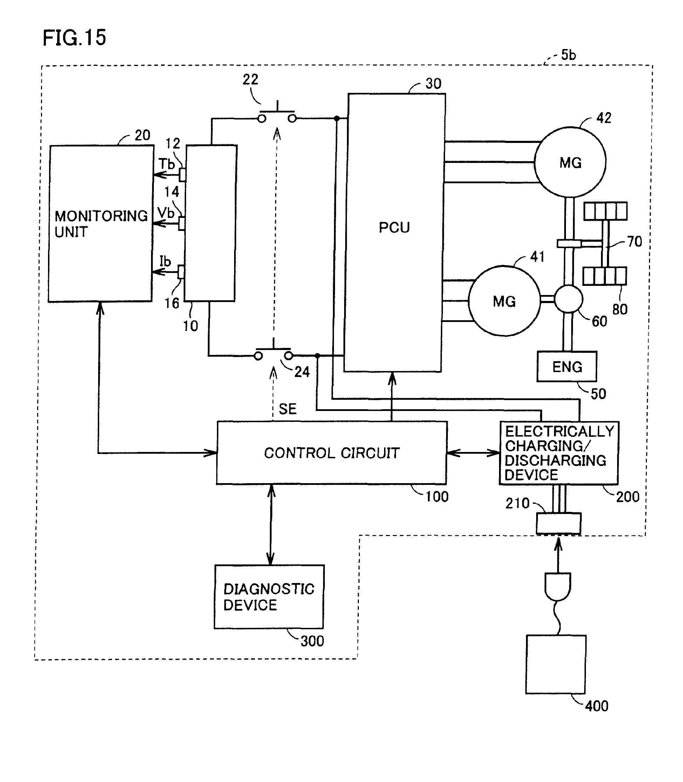

Fig. 15 is a block diagram for illustrating a schematic configuration of a vehicle 5b according to the third embodiment. As shown in Fig. 15, vehicle 5b has diagnostic device 300 therein. Note that diagnostic device 300 may be integrated with control circuit 100.

Furthermore, vehicle 5b is a so-called plug-in vehicle and can charge battery 10 with the power of an external power supply 310 having a charging and discharging function. Vehicle 5b includes a connector 210 configured to be connectable to external power supply 310, and a charging/discharging device 200 provided between battery 10 and connector 210. The remainder in structure, function, and process are identical to that of the first embodiment, and accordingly, it will not be described repeatedly in detail.

Charging/discharging device 200 operates in response to a signal received from control circuit 100 to charge battery 10 from an external power supply 400 and discharge battery 10 to external power supply 400.

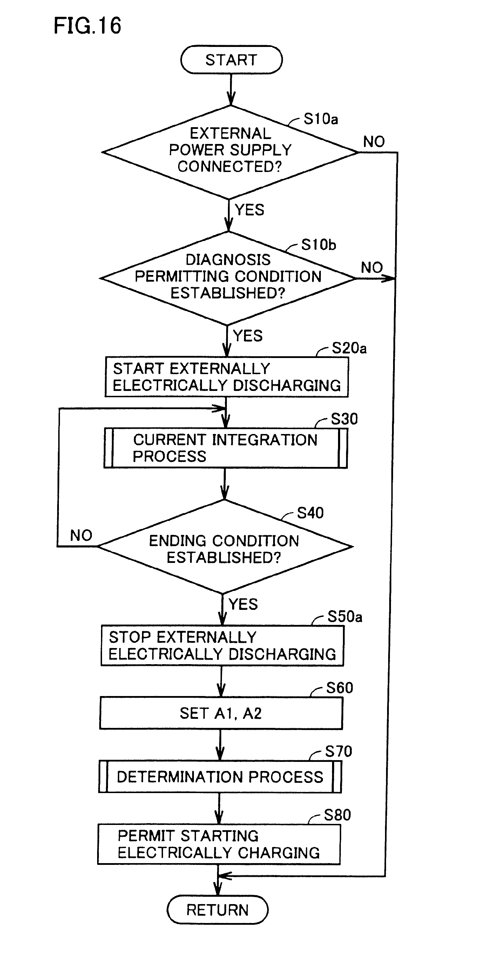

Fig. 16 is a flowchart representing a procedure of a process performed by diagnostic device 300 according to the third embodiment. Note that in the Fig. 16 flowchart, those steps which are identical to those in the Fig. 6 flowchart are identically denoted. Accordingly they will not be described repeatedly in detail.

In S 10a, diagnostic device 300 determines whether external power supply 400 has been connected to connector 210. If so (YES at S10a), the control proceeds to S10b. Otherwise (NO at S10a), this process ends.

In S10b, diagnostic device 300 determines whether a condition has been established to permit the diagnosis. The condition to permit the diagnosis is that battery 10 has stored therein an amount of power smaller than a predetermined amount, i.e., falling within the low SOC range. Note that, for the low SOC range, block voltage Vb is lower than a predetermined value, and accordingly, the condition to permit the diagnosis may be such that block voltage Vb is lower than the predetermined value. Furthermore, another condition to permit the diagnosis may additionally be introduced such that battery 10 has been used beyond a predetermined period of years. If the condition to permit the diagnosis is established, (YES at S10b) the control proceeds to S20a. Otherwise (NO at S10b), this process ends.

In S20a, diagnostic device 300 starts discharging battery 10 to external power supply 400.

In S50a, diagnostic device 300 stops discharging battery 10 to external power supply 400.

In S80, diagnostic device 300 permits starting charging battery 10 from external power supply 400. This starts charging battery 10 from external power supply 400.

Thus, in the third embodiment, diagnostic device 300 is included in vehicle 5b that can charge battery 10 with the power of external power supply 400, and when external power supply 400 is connected to a plug-in vehicle (or when the user is going to start charging battery 10 from external power supply 400) battery 10 has its electric charge discharged to external power supply 400 for the battery diagnosis.

This allows the battery diagnosis to be conducted without bringing vehicle 5b to a service shop. Furthermore, discharging to external power supply 400 allows battery 10 to stably discharge, and the current integration process can thus be performed to calculate an integrated value of battery current Ib with high precision.

Furthermore, the battery diagnosis is not conducted whenever external power supply 400 is connected to the plug-in vehicle; rather, the battery diagnosis is conducted only when battery 10 falls within the low SOC range allowing the low-range characteristic of battery 10 to be utilized. Accordingly, decreasing battery 10 from a range with a large amount of power stored therein to the low SOC range only for the battery diagnosis, and hence wasteful power consumption, can be avoided.

Third Embodiment in Exemplary Variation

In the third embodiment, the battery diagnosis is conducted before charging battery 10 from external power supply 400 starts, and accordingly, each block voltage Vb will decrease to measurement ending voltage Ve. In such a case, after the battery diagnosis is conducted, battery 10 may have its electric charge further discharged to external power supply 400 so that battery 10 may once have substantially no amount of power (a value of power slightly larger than zero) stored therein and subsequently, charging battery 10 from external power supply 400 may be started, and after charging battery 10 is started until battery 10 is fully charged battery 10 is charged with an amount of electric charge, which may be measured as a power storage capacity of battery 10. Note that whether battery 10 has been fully charged may be determined for example from whether block voltage Vb has reached a voltage corresponding to the fully charged state.

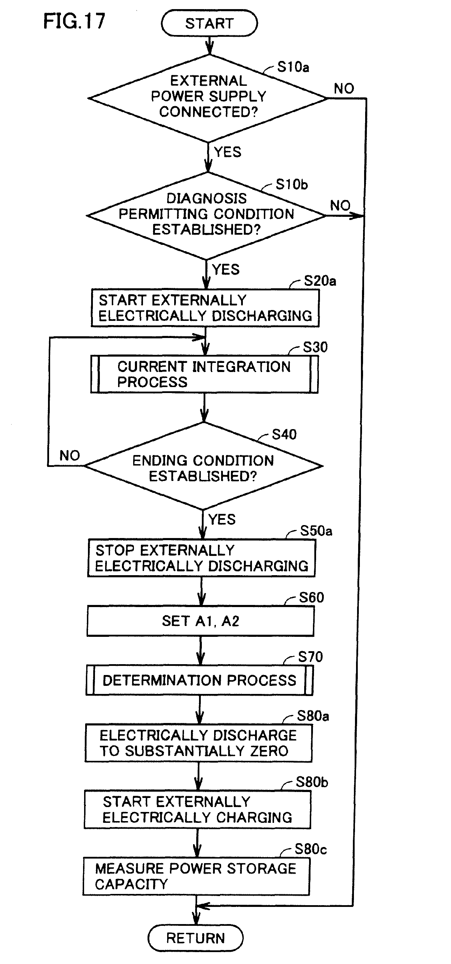

Fig. 17 is a flowchart representing a procedure of a process performed by diagnostic device 300 according to the third embodiment in the exemplary variation. Note that in the Fig. 17 flowchart, those steps which are identical to those in the Fig. 16 flowchart are identically denoted. Accordingly they will not be described repeatedly in detail.

After the S70 determination process, diagnostic device 300 in S80a causes battery 10 to further discharge electric charge to external power supply 400 until battery 10 has substantially no amount of power stored therein.

After the amount of power stored in battery 10 is substantially zeroed, diagnostic device 300 in S80b permits starting charging battery 10 from external power supply 400. This starts charging battery 10 from external power supply 400.

After charging battery 10 is started until battery 10 is fully charged, battery 10 is charged with an amount of electric charge, which corresponds to an integrated value of battery current Ib, which diagnostic device 300 in S80c measures as a power storage capacity of battery 10.

By thus performing the above process when charging battery 10 from external power supply 400 starts, whether battery 10 is degraded and accordingly has a reduced power storage capacity can be detected periodically with high precision.

### Fourth Embodiment

As has been set forth at the beginning of the second embodiment, while determining a degraded state of battery 10 with high precision requires setting measurement starting voltage Vs at a relatively small value, measurement starting voltage Vs having an excessively small value results in low precision for determination.

In view of this, in the fourth embodiment, if block voltage Vb is lower than a reference voltage, it is determined that the current integration process cannot be started at measurement starting voltage Vs, and the diagnosis is avoided. Hereinafter will be described an example with a reference voltage set at measurement starting voltage Vs.

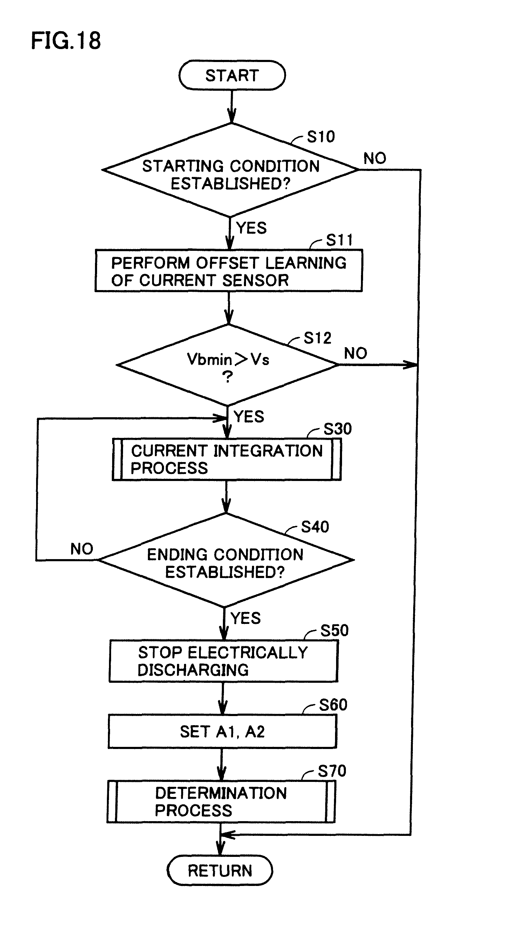

Fig. 18 is a flowchart representing a procedure of a process performed by diagnostic device 300 according to the fourth embodiment in an exemplary variation. Note that in the Fig. 18 flowchart, those steps which are identical to those in the Fig. 6 flowchart are identically denoted. Accordingly they will not be described repeatedly in detail.

In S 11, diagnostic device 300 performs an offset learning of current sensor 16. Diagnostic device 300 stores as an offset amount a value output from current sensor 16 without battery 10 being charged/discharged. Diagnostic device 300 corrects the value that is sensed by current sensor 16 with the offset amount to determine battery current Ib.

In S 12 diagnostic device 300 determines whether block voltages Vb1-Vbn have a lowest block voltage Vb higher than measurement starting voltage Vs (or the reference voltage).

If so (YES at S12), diagnostic device 300 causes the control to proceed to S30 et seq. to conduct the battery diagnosis.

Otherwise (NO at S12), diagnostic device 300 ends the process and does not conduct the battery diagnosis.

Thus when the battery diagnosis would be conducted with low precision for determination, the battery diagnosis can be avoided to prevent erroneous determination.

Note that the battery diagnosis is conducted with low precision for determination because of block voltage Vb as well as battery temperature Tb and battery current Ib. Lower battery temperature Tb and larger battery current Ib have a tendency to result in lower precision for detection. Accordingly in Fig. 18, steps S 12 and S40 determine whether block voltage Vb is higher than measurement starting voltage Vs, and in addition, whether battery temperature Tb falls within a predetermined temperature range and whether battery current Ib falls within a predetermined range may be determined, and if at least one of the conditions is not satisfied, the battery diagnosis may be avoided to prevent erroneous determination.

It should be understood that the embodiments disclosed herein are illustrative and non-restrictive in any respect. The scope of the present invention is defined by the terms of the claims, rather than the description above, and is intended to include any modifications within the scope and meaning equivalent to the terms of the claims.

### REFERENCE SIGNS LIST

5, 5b: vehicle; 10: battery; 10a: battery cell; 11: battery block; 12: temperature sensor; 14: voltage sensor; 16: current sensor; 20: monitoring unit; 22, 24: system main relay; 41, 42: motor generator; 50: engine; 60: power split device; 70: driving shaft; 80: wheel; 100, 100a: control circuit; 110, 311, 311a: integration unit; 120: storage unit; 200: charging/discharging device; 210: connector; 300, 300a: diagnostic device; 310, 310a: calculation unit; 312: termination unit; 320: diagnostic unit; 321: determination unit; 322: setting unit; 400: external power supply.

## Claims

1. A diagnostic device for a rechargeable battery (10), comprising:
a calculation unit (310) that performs a calculation process by discharging said rechargeable battery and calculating as an amount of power discharged for a diagnosis an amount of electric charge discharged by said rechargeable battery while said rechargeable battery decreases in voltage from a first voltage to a second voltage lower than said first voltage with said rechargeable battery having stored therein an amount of power smaller than a predetermined amount; and
a diagnostic unit (320) that performs for said rechargeable battery a degradation diagnosis based on said amount of power discharged for said diagnosis.

2. The diagnostic device for a rechargeable battery according to claim 1, wherein said diagnostic unit sets a threshold value used in said degradation diagnosis, based on a value of a current discharged by said rechargeable battery in said calculation process and a temperature of said rechargeable battery in said calculation process, and said diagnostic unit conducts said degradation diagnosis based on a result of having compared with said threshold value said amount of power discharged for said diagnosis.

3. The diagnostic device for a rechargeable battery according to claim 1, wherein said diagnostic unit sets a first threshold value used in said degradation diagnosis, based on a value of a current discharged by said rechargeable battery in said calculation process and a lowest temperature in said rechargeable battery in said calculation process, and said diagnostic unit diagnoses from a result of having compared with said first threshold value said amount of power discharged for said diagnosis whether said rechargeable battery is in a first condition indicating that said rechargeable battery is substantially undegraded.

4. The diagnostic device for a rechargeable battery according to claim 3, wherein: said diagnostic unit sets said first threshold value and in addition thereto a second threshold value smaller than said first threshold value; and if said amount of power discharged for said diagnosis is larger than said first threshold value, said diagnostic unit diagnoses that said rechargeable battery is in said first condition, if said amount of power discharged for said diagnosis is smaller than said first threshold value and larger than said second threshold value, said diagnostic unit diagnoses that said rechargeable battery is in a second condition indicating that said rechargeable battery is more degraded than said first condition but can still continue to be used, and if said amount of power discharged for said diagnosis is smaller than said second threshold value, said diagnostic unit diagnoses that said rechargeable battery is in a third condition indicating that said rechargeable battery is more degraded than said second condition and can no longer continue to be used.

5. The diagnostic device for a rechargeable battery according to claim 1, wherein if said rechargeable battery has stored therein an amount of power smaller than said predetermined amount said calculation unit performs said calculation process, whereas if said rechargeable battery has stored therein an amount of power larger than said predetermined amount said calculation unit does not perform said calculation process.

6. The diagnostic device for a rechargeable battery according to claim 1, wherein if said rechargeable battery is higher in voltage than said first voltage said calculation unit performs said calculation process, whereas if said rechargeable battery is lower in voltage than said first voltage said calculation unit does not perform said calculation process.

7. The diagnostic device for a rechargeable battery according to claim 1, wherein:
said rechargeable battery is mounted in a vehicle capable of travelling by power of said rechargeable battery;
said vehicle includes a control device (100) that calculates and stores as a first amount of power discharged an amount of electric charge discharged by said rechargeable battery while said rechargeable battery decreases in voltage from said first voltage to an intermediate voltage between said first voltage and said second voltage, if a predetermined condition is established while said vehicle is traveling: and
when said calculation unit performs said calculation process, said calculation unit obtains from said control device said first amount of power discharged, and said calculation unit considers said first amount of power discharged and accordingly calculates said amount of power discharged for said diagnosis.

8. The diagnostic device for a rechargeable battery according to claim 7, wherein said calculation unit calculates as a second amount of power discharged an amount of electric charge discharged by said rechargeable battery with said vehicle stopped while said rechargeable battery decreases in voltage from said intermediate voltage to said second voltage, and said calculation unit calculates as said amount of power discharged for said diagnosis said first amount of power discharged plus said second amount of power discharged.

9. The diagnostic device for a rechargeable battery according to claim 1, wherein:
said rechargeable battery and said diagnostic device are mounted in a vehicle which is capable of travelling by power of said rechargeable battery and includes a charging/discharging device for allowing an external power supply and said rechargeable battery to communicate power therebetween; and
when said external power supply is connected to said vehicle, said calculation unit controls said charging/discharging device to cause said rechargeable battery to discharge to said external power supply and thus performs said calculation process.

10. The diagnostic device for a rechargeable battery according to claim 9, wherein when said external power supply is connected to said vehicle, and if said rechargeable battery has stored therein an amount of power smaller than a predetermined amount, said diagnostic device causes said rechargeable battery to discharge to said external power supply to allow said rechargeable battery to have substantially no amount of power stored therein and subsequently starts charging said rechargeable battery, and measures as a power storage capacity of said rechargeable battery an amount of electric charge charged to said rechargeable battery after charging said rechargeable battery is started until said rechargeable battery is fully charged.

11. The diagnostic device for a rechargeable battery according to claim 1, wherein said rechargeable battery is a rechargeable lithium ion battery.

12. A vehicle comprising a rechargeable battery (10) which can be subjected to a diagnosis for a degraded state by a diagnostic device (300), said diagnostic device conducting for said rechargeable battery a degradation diagnosis based on an amount of electric charge discharged by said rechargeable battery while said rechargeable battery decreases in voltage from a first voltage to a second voltage lower than said first voltage with said rechargeable battery having stored therein an amount of power smaller than a predetermined amount, the vehicle comprising:
a calculation unit (110) that calculates as a first amount of power discharged an amount of electric charge discharged by said rechargeable battery while said rechargeable battery decreases in voltage from said first voltage to an intermediate voltage between said first voltage and said second voltage, if a predetermined condition is established while the vehicle is travelling; and
a storage unit (120) that stores said first amount of power discharged therein to enable said diagnostic device to obtain said first amount of power discharged,
while the vehicle is stopped, said diagnostic device obtaining from said storage unit said first amount of power discharged, said diagnostic device considering said first amount of power discharged, and accordingly conducting said degradation diagnosis.

13. The vehicle according to claim 12, having said diagnostic device therein.

14. A method for a diagnosis conducted by a diagnostic device (300) for a rechargeable battery (10), comprising the steps of:
performing a calculation process by discharging said rechargeable battery and calculating as an amount of power discharged for said diagnosis an amount of electric charge discharged by said rechargeable battery while said rechargeable battery decreases in voltage from a first voltage to a second voltage lower than said first voltage with said rechargeable battery having stored therein an amount of power smaller than a predetermined amount; and
conducting for said rechargeable battery a degradation diagnosis based on said amount of power discharged for said diagnosis.
